(19)

Europäisches
Patentamt
European
Patent Office
Office européen
des brevets

(11) **EP 2 187 463 A1**

(12) **EUROPEAN PATENT APPLICATION**
published in accordance with Art. 153(4) EPC

(43) Date of publication:
   **19.05.2010 Bulletin 2010/20**

(51) Int Cl.:
   *H01L 51/50* (2006.01)   *G09F 9/30* (2006.01)
   *H01L 27/32* (2006.01)   *H05B 33/02* (2006.01)
   *H05B 33/12* (2006.01)

(21) Application number: **08828075.5**

(22) Date of filing: **27.08.2008**

(86) International application number:
   **PCT/JP2008/065293**

(87) International publication number:
   **WO 2009/028547 (05.03.2009 Gazette 2009/10)**

(84) Designated Contracting States:
   **AT BE BG CH CY CZ DE DK EE ES FI FR GB GR
   HR HU IE IS IT LI LT LU LV MC MT NL NO PL PT
   RO SE SI SK TR**
   Designated Extension States:
   **AL BA MK RS**

(30) Priority: **30.08.2007 JP 2007224456**

(71) Applicant: **Sony Corporation
   Tokyo 108-0075 (JP)**

(72) Inventor: **FUKUDA, Toshihiro
   Tokyo 108-0075 (JP)**

(74) Representative: **Zinke, Thomas
   Müller Hoffmann & Partner
   Patentanwälte
   Innere Wiener Straße 17
   D-81667 München (DE)**

(54) **DISPLAY APPARATUS**

(57)    A display apparatus including a self-luminous type light emitting device with which view angle characteristics of luminance are able to be improved is provided. An organic EL device (light emitting sections 16R, 16G, and 16B) as a self-luminous type light emitting device and a black matrix layer BM are provided, and Formula (11) and Formula (16) are satisfied. In the view angle α range from 0 to 60 deg both inclusive, vignetting of display light L from the light emitting sections 16R, 16G, and 16B (organic EL device) caused by light shielding by the black matrix layer BM is never generated. Meanwhile, in the case where Formula (11), Formula (19), and Formula (23) are satisfied, even if vignetting of the display light L from the organic EL device caused by light shielding by the black matrix layer BM is generated in the view angle α range from 0 to 60 deg both inclusive, the vignetting ratio of the display light L is suppressed to a value equal to or less than 50%.

FIG. 1

**Description**

TECHNICAL FIELD

The present invention relates to a display apparatus including a self-luminous type light emitting device such as an organic EL (Electro Luminescence) device.

BACKGROUND ART

In a display apparatus, view angle characteristics of luminance are a factor significantly affecting the display image quality. In general, in the case where a self-luminous type light emitting device (self-luminous device) such as an organic EL device is used, light emitting itself is perfect diffusion. Further, due to micro cavity effect of the resonator structure and the like, even in the case of using a device structure in which extraction efficiency in the front face direction is improved, the light emitting section is able to be designed as a section similar to a perfect diffusion light source. Thus, it has been regarded that the self-luminous device is advantageous to the view angle characteristics of luminance.

However, in the case where a display apparatus is structured by using such a self-luminous device, in some case, in order to realize high contrast, a black matrix layer is provided for the purpose of inhibiting reflection from a backplane (one of a pair of substrates that is located on the opposite side of the display face) of outside light. Further, in order to improve color purity in addition to high contrast, in some cases, a black matrix layer structured integrally with a color filter is provided.

In the self-luminous type light emitting device provided with such a black matrix layer, the black matrix layer is arranged on the substrate arranged opposite to the backplane out of the pair of substrates. In order to form the black matrix layer on the backplane, the light emitting device is required to have heat resistance and reliability. However, in the existing circumstances, a material satisfying the foregoing requirement does not exist. Accordingly, it is almost essential that the black matrix layer is formed on the opposed substrate side.

Thus, when the backplane and the opposed substrate on which the black matrix layer is formed are aligned and bonded to each other, a distance corresponding to a thickness of an adhesive layer for bonding (sealing layer) and a thickness of a protective layer exists between the light emitting section and the black matrix layer.

Examples of the self-luminous type display apparatus having such a self-luminous type light emitting layer include an organic EL display apparatus (for example, Patent Document 1).

Patent Document 1: Japanese Unexamined Patent Application Publication No. 2006-73219

DISCLOSURE OF INVENTION

In the case of a self-luminous device such as an organic EL device, though light emitting itself is perfect diffusion, the size of the light emitting section is limited to the size equal to or less than a pixel pitch size. Thus, in the case where a light shielding black matrix layer or the like exists, when a pixel is viewed from a diagonal direction, a shadow section created by the black matrix layer is generated. Accordingly, there has been a problem that the shadow section extends to the light emitting section, a light shielding region is thereby generated, and the luminance is lowered according to the size of the light shielding region (view angle characteristics of luminance are deteriorated). In the case of the light emitting device in which micro cavity effect is used, the foregoing problem is overlapped with light distribution characteristics of the light emitting section, and thereby deterioration of view angle characteristics of the luminance becomes more significant.

The foregoing light shielding phenomenon is a phenomenon unique to the display apparatus including the self-luminous device having a finite size. Such a light shielding phenomenon is not generated in a liquid crystal display apparatus in which a perfect diffusion light source (backlight light source) is arranged separately from a liquid crystal panel. This is because in the liquid crystal panel with a thin cell gap, the perfect diffusion backlight light source having a larger dimension than that of an aperture region is able to be regarded as a virtual diffusion light source formed directly beneath the black matrix layer. Thus, the view angle characteristics of luminance almost correspond with those of the light source, resulting in almost no problem. In fact, the actual problem as the visual field characteristics in the liquid crystal display apparatus is contrast degradation caused by spectroscopic characteristics of refractive index anisotropy of liquid crystal molecules and color shift caused by the wavelength dependence.

Further, in the past, no inventions for solving luminance degradation caused by light shielding as view angle characteristics described above have existed. For example, as described in the foregoing Patent Document 1, only a technique in which color mixture generated in the case where light leaked from one pixel to an adjacent pixel enters the interface between air and a glass at an angle equal to or more than a critical angle is avoided has been reported.

In view of the foregoing problem, it is an object of the invention to provide a display apparatus including a self-luminous type light emitting device with which view angle characteristics of luminance can be improved.

In a first display apparatus of the present invention, a plurality of pixels are arranged in a state of matrix as a whole; a pair of substrates, a self-luminous type light emitting device formed in a region corresponding to each pixel on one substrate of the pair of substrates, and a black matrix layer formed in a region corresponding to a portion between each pixel on the other substrate of the pair of substrates are included; and the following Formula (1) is satisfied.

$$2\sqrt{3} \leq (|W_{BM}-W_{LD}|/D) \quad (1)$$

In the formula, $W_{BM}$ represents an aperture dimension of the black matrix layer; $W_{LD}$ represents a light emitting region dimension of the light emitting device; and D represents an air length between the light emitting device and the black matrix layer, respectively.

In the first display apparatus of the present invention, since the foregoing Formula (1) is satisfied, in the view angle range from 0 degrees to 60 degrees both inclusive, vignetting of display light from the light emitting device caused by light shielding by the black matrix layer is never generated.

In a second display apparatus of the present invention, a plurality of pixels are arranged in a state of matrix as a whole; a pair of substrates, a self-luminous type light emitting device formed in a region corresponding to each pixel on one substrate of the pair of substrates, and a black matrix layer formed in a region corresponding to a portion between each pixel on the other substrate of the pair of substrates are included; and the following Formula (2) to Formula (4) are satisfied.

$$2\sqrt{3} > (|W_{BM}-W_{LD}|/D) \quad (2)$$

$$W_{LD} < W_{BM} \quad (3)$$

$$(\sqrt{3}/2)*W_{BM} \geq D \geq (1/2\sqrt{3})*(W_{BM}-W_{LD}) \quad (4)$$

In the formula, $W_{BM}$ represents an aperture dimension of the black matrix layer; $W_{LD}$ represents a light emitting region dimension of the light emitting device; and D represents an air length between the light emitting device and the black matrix layer.

In the second display apparatus of the present invention, since the foregoing Formula (2) to Formula (4) are satisfied, in the case where the aperture dimension of the black matrix layer is larger than the light emitting region dimension of the light emitting device, even if vignetting of the display light from the light emitting device caused by light shielding by the black matrix layer is generated in the view angle range from 0 degrees to 60 degrees both inclusive, the vignetting ratio of the display light can be suppressed to a value equal to or less than 50%.

In a third display apparatus of the present invention, a plurality of pixels are arranged in a state of matrix as a whole; a pair of substrates, a self-luminous type light emitting device formed in a region corresponding to each pixel on one substrate of the pair of substrates, and a black matrix layer formed in a region corresponding to a portion between each pixel on the other substrate of the pair of substrates are included; and the following Formula (5) to Formula (7) are satisfied.

$$2\sqrt{3} > (|W_{BM}-W_{LD}|/D) \quad (5)$$

$$W_{LD} \geq W_{BM} \quad (6)$$

$$(\sqrt{3}/2)*W_{LD} \geq D \geq (1/2\sqrt{3})*(W_{LD}-W_{BM}) \quad (7)$$

In the formula, $W_{BM}$ represents an aperture dimension of the black matrix layer; $W_{LD}$ represents a light emitting region dimension of the light emitting device; and D represents an air length between the light emitting device and the black matrix layer.

In the third display apparatus of the present invention, since the foregoing Formula (5) to Formula (7) are satisfied, in the case where the aperture dimension of the black matrix layer is equal to or less than the light emitting region dimension of the light emitting device, even if vignetting of the display light from the light emitting device caused by light shielding by the black matrix layer is generated in the view angle range from 0 degrees to 60 degrees both inclusive, the vignetting ratio of the display light can be suppressed to a value equal to or less than 50%.

According to the first display apparatus of the present invention, the self-luminous type light emitting device and the black matrix layer are provided, and the foregoing Formula (1) is satisfied. Thus, in the view angle range from 0 deg to 60 deg both inclusive, vignetting of display light from the light emitting device caused by light shielding by the black matrix layer is never generated. Therefore, in the display apparatus including the self-luminous type light emitting device, view angle characteristics of luminance are able to be improved.

According to the second display apparatus of the present invention, the self-luminous type light emitting device and the black matrix layer are provided, and the foregoing Formula (2) to Formula (4) are satisfied. Thus, in the case where the aperture dimension of the black matrix layer is larger than the light emitting region dimension of the light emitting device, even if vignetting of the display light from the light emitting device caused by light shielding by the black matrix layer is generated in the view angle range from 0 degrees to 60 degrees both inclusive, the vignetting ratio of the display light can be suppressed to a value equal to or less than 50%. Therefore, in the display apparatus including the self-luminous type light emitting device, view angle characteristics of luminance are able to be improved.

According to the third display apparatus of the present invention, the self-luminous type light emitting device and the black matrix layer are provided, and the foregoing Formula (5) to Formula (7) are satisfied. Thus, if the aperture dimension of the black matrix layer is equal to or less than the light emitting region dimension of the light emitting device, even if vignetting of the display light from the light emitting device caused by light shielding by the black matrix layer is generated in the view angle range from 0 degrees to 60 degrees both inclusive, the vignetting ratio of the display light can be suppressed to a value equal to or less than 50%. Therefore, in the display apparatus including the self-luminous type light emitting device, view angle characteristics of luminance are able to be improved.

BRIEF DESCRIPTION OF DRAWINGS

[FIG. 1] FIG. 1 is a cross sectional view illustrating a configuration of a display apparatus according to a first embodiment of the present invention.
[FIG. 2] FIG. 2 is a cross sectional view illustrating a detailed structure of the light emitting section illustrated in FIG. 1.
[FIG. 3] FIG. 3 is a characteristics diagram illustrating an example of a relation between a view angle and a relative luminance.
[FIG. 4] FIG. 4 is a cross sectional view illustrating a configuration of a display apparatus according to a second embodiment.
[FIG. 5] FIG. 5 is a plan view for explaining a pixel shape in a display apparatus according to a modified example of the present invention.

BEST MODE(S) FOR CARRYING OUT THE INVENTION

A description will be hereinafter given in detail of embodiments of the present invention with reference to the drawings.

[First embodiment]

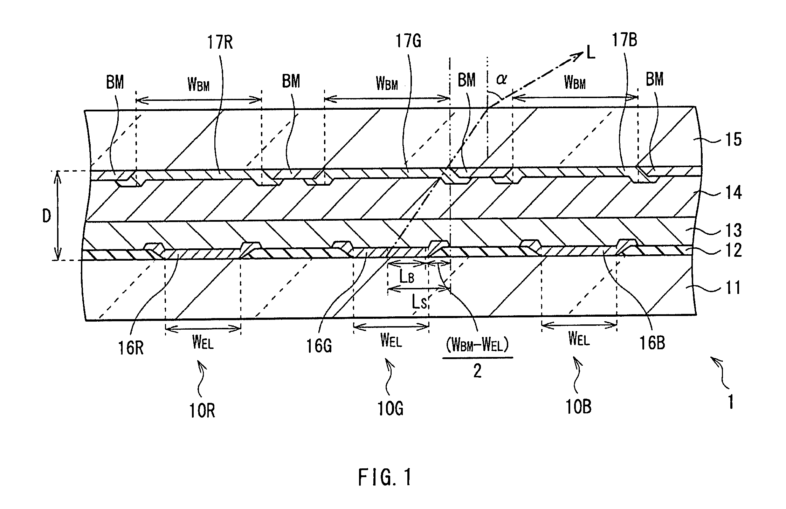

Fig. 1 illustrates a cross sectional configuration of a display apparatus (organic EL display apparatus 1) according to a first embodiment of the present invention. In the organic EL display apparatus 1, for example, an after-mentioned plurality of light emitting sections 16R, 16G, and 16B are respectively arranged in a state of matrix in pixels 10R, 10G, and 10B on a drive substrate 11 made of glass or the like, and a signal line drive circuit and a scanning line drive circuit (not illustrated) that are pixel drive circuits for displaying a video are formed. Specifically, the light emitting sections 16R, 16G, and 16B, an insulating layer 12, a protective layer 13, a sealing layer 14, color filter layers 17R, 17B, and 17G, and a black matrix layer BM are layered in this order from the drive substrate 11 side between the drive substrate 11 and an opposed substrate 15.

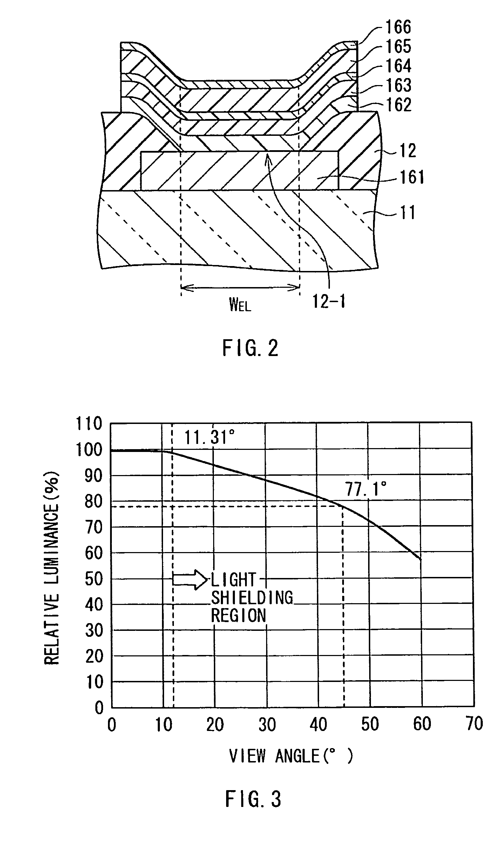

The light emitting sections 16R, 16G, and 16B are respectively formed in a region corresponding to the pixels 10R, 10G, and 10B, and are composed of self-luminous type light emitting devices (organic EL devices) emitting light in a red wavelength region, a green wavelength region, and a blue wavelength region. FIG. 2 illustrates a cross sectional structure of the organic EL device in detail. The organic EL device has a structure in which a drive transistor of the foregoing pixel drive circuit (not illustrated); a first electrode 161 as an anode; a hole injection layer 162, a hole transport layer 163, a light emitting layer 164, and an electron transport layer 165 as an organic layer; and a second electrode 166 as a cathode are layered in this order from the drive substrate 11 side.

Such an organic EL device is covered with the protective layer 13 composed of silicon nitride (SiNx) or the like, and is further sealed by bonding the opposed substrate 15 made of glass or the like to the whole area of the protective layer 13 with the sealing layer 14 in between. The distance between the light emitting sections 16R, 16G, and 16B and the black matrix layer BM is about 30 μm, which includes the thickness of the protective layer 13 and the thickness of the adhesive layer 14. The drive transistor is electrically connected to the first electrode 161 through an aperture 12-1 provided in the insulating film 12.

The first electrode 161 is made of, for example, ITO (indium tin composite oxide).

As described above, the organic layer in the light emitting sections 16R, 16G, and 16B has the structure in which the hole injection layer 162, the hole transport layer 163, the light emitting layer 164, and the electron transport layer 165 are layered sequentially from the first electrode 161 side. Of the foregoing, it is enough that layers other than the light emitting layer 164 are provided according to needs. Further, such an organic layer may have different structures according to each light emitting color of the organic EL device. The hole injection layer 161 is intended to improve hole injection efficiency and a buffer layer to prevent leakage. The hole transport layer 163 is intended to improve hole transport efficiency to the light emitting layer 164. The light emitting layer 164 emits light by electron-hole recombination by applying an electric field. As will be described in detail below, the light emitting layer 164 contains a host material having charge transport characteristics and a dopant material (guest material) having light emitting characteristics. The electron transport layer 165 is intended to improve electron transport efficiency to the light emitting layer 164. It is possible that an electron injection layer (not illustrated) that has, for example, a thickness of about 0.3 nm and is composed of LiF and $Li_2O$ or the like is provided between the electron transport layer 165 and the second electrode 166.

The hole injection layer 162 of the light emitting section 16R has, for example, a thickness from 5 nm to 300 nm both inclusive, and is composed of 4,4',4"-tris(3-methylphenylphenylamino)triphenyl amine (m-MTDATA) or 4,4',4"-tris(2-naphthylphenylamino)triphenyl amine (2-TNATA). The hole transport layer 163 of the light emitting section 16R has, for example, a thickness from 5 nm to 300 nm both inclusive, and is composed of bis[(N-naphthyl)-N-phenyl] benzidine (α-NPD). The light emitting layer 164 of the light emitting section 16R has, for example, a thickness from 10 nm to 100 nm both inclusive, and is composed of a material in which 30 wt% of 2, 6≡bis[4'≡methoxydiphenylamino) styryl]≡1,5≡dicyanonaphthalene (BSN) as a dopant material is mixed with 9,10-di-(2-naphtyl)anthracene (ADN) (host material) as a host material. The electron transport layer 165 of the light emitting section 16R has, for example, a thickness from 5 nm to 300 nm both inclusive, and is composed of 8≡hydroxyquinoline aluminum ($Alq_3$).

The hole injection layer 162 of the light emitting section 16G has, for example, a thickness from 5 nm to 300 nm both inclusive, and is composed of m-MTDATA or 2-TNATA. The hole transport layer 163 of the light emitting section 16G has, for example, a thickness from 5 nm to 300 nm both inclusive, and is composed of α-NPD. The light emitting layer 164 of the light emitting section 16G has, for example, a thickness from 10 nm to 100 nm both inclusive, and is composed of a material in which 5 volume% of Coumarin 6 as a dopant material is mixed with ADN as a host material. The electron transport layer 165 of the light emitting section 16G has, for example, a thickness from 5 nm to 300 nm both inclusive, and is composed of $Alq_3$.

The hole injection layer 162 of the light emitting section 16B has, for example, a thickness from 5 nm to 300 nm both inclusive, and is composed of m-MTDATA or 2-TNATA. The hole transport layer 163 of the light emitting section 16B has, for example, a thickness form 5 nm to 300 nm both inclusive, and is composed of α-NPD. The light emitting layer 164 of the light emitting section 16B has, for example, a thickness from 10 nm to 100 nm both inclusive, and is composed of a material in which 2.5 wt% of 4,4'≡bis[2≡{4≡(N,N≡diphenylamino)phenyl}vinyl]biphenyl (DPAVBi) as a dopant material is mixed with ADN as a host material. The electron transport layer 165 of the light emitting section 16B has, for example, a thickness from 5 nm to 300 nm both inclusive, and is composed of $Alq_3$.

The second electrode 166 has, for example, a thickness from 5 nm to 50 nm both inclusive, and is composed of a simple substance or an alloy of metal elements such as aluminum (Al), magnesium (Mg), calcium (Ca), and sodium (Na). Specially, an alloy of magnesium and silver (MgAg alloy) or an alloy of aluminum (Al) and lithium (Li) (AlLi alloy) is preferable.

The insulating layer 12 is intended to planarize the surface of the drive substrate 11, and is composed of, for example, an organic material such as polyimide or an inorganic material such as silicon oxide ($SiO_2$).

The protective layer 13 is intended to prevent intrusion of moisture or the like into the organic layer in the light emitting sections 16R, 16G, and 16B. The protective layer 13 is made of a material having low water permeable characteristics and low water absorbing characteristics, and has a sufficient thickness. Further, the protective layer 13 is made of a material having high transmissive characteristics to light generated in the light emitting layer 164 such as a material having a transmittance equal to or more than 80%. Such a protective layer 13 has, for example, a thickness about from 2 μm to 3 μm both inclusive, and is made of an inorganic amorphous insulating material. Specifically, the protective layer 13 is preferably composed of amorphous silicon (α-Si), amorphous silicon carbide (α-SiC), amorphous silicon nitride ($α\text{-}Si_{1-x}N_x$), or amorphous carbon (α-C). Such an inorganic amorphous insulating material does not compose grains, and thus has low water permeability characteristics and structures the favorable protective layer 13. Further, the protective layer 13 may be made of a transparent conductive material such as ITO.

The sealing layer 14 is made of, for example, a thermosetting resin or an ultraviolet ray curable resin.

The opposed substrate 15 is located on the second electrode 166 side of the light emitting sections 16R, 16G, and 16B. The opposed substrate 15 is intended to seal the light emitting sections 16R, 16G, and 16B together with the sealing layer 14, and is made of a material such as glass transparent to light generated in the light emitting sections 16R, 16G, and 16B. The opposed substrate 15 is provided with, for example, the color filter layers 17R, 17G, and 17B, which extract light generated in the light emitting sections 16R, 16G, and 16B and absorb outside light reflected by the light emitting sections 16R, 16G, and 16B and wirings therebetween to improve contrast. The opposed substrate 15 is further provided with the after-mentioned black matrix layer BM.

The color filter layers are composed of the color filter layer 17R as a red filter, the color filter layer 17G as a green filter, and the color filter layer 17B as a blue filter. The color filter layers are arranged for each pixel correspondingly to the light emitting sections 16R, 16G, and 16B. The color filter layers 17R, 17G, and 17B are respectively, for example, in the shape of a rectangle, and are formed with no space therebetween. These color filter layers 17R, 17G, and 17B are respectively made of a resin mixed with a pigment. By selecting the pigment, adjustment is made so that the light transmission ratio in the targeted red, green, or blue wavelength region is high and the light transmission ratio in the other wavelength regions is low.

The black matrix layer BM is formed in a region corresponding to a region between the pixels 10R, 10G, and 10B. The black matrix layer BM is intended to segment the display regions of the pixels 10R, 10G, and 10B, and prevent reflection of outside light in a border between each color section and prevent light leakage in a portion between the pixels to improve contrast. The black matrix layer BM is composed of a laminated body of thin film layers composed of a metal, a metal oxide, and a metal nitride. For example, the black matrix layer BM is made of a two-layer chromium black matrix composed of a lamination of $CrO_x$ ($x$ is a given number) and Cr or a three-layer chromium black matrix composed of a lamination of $CrO_x$, $CrN_y$, and Cr (x and y are a given number) having a decreased reflectance.

Next, a description will be given in detail of a structure of a characteristic part of the present invention and action and effect thereby obtained with reference to FIG. 1 and FIG. 3.

(Case with no vignetting)

First, in the organic EL display apparatus 1 of this embodiment, as illustrated in FIG. 1, where an aperture dimension of the black matrix layer BM is $W_{BM}$; a light emitting region dimension of the organic EL device in the light emitting sections 16R, 16G, and 16B is $W_{EL}$ (corresponding to a specific example of a light emitting region dimension $W_{LD}$); and a value obtained by converting a distance in the vertical direction between the light emitting sections 16R, 16G, and 16B (organic EL device) and the black matrix layer BM to an air length is D (=Edi/ni), magnitude relation between the aperture dimension $W_{BM}$ of the black matrix layer BM and the light emitting region dimension $W_{EL}$ of the organic EL device satisfies the following Formula (11) in order to avoid lowering of light usage efficiency due to hiding the light emitting region. That is, the aperture dimension $W_{BM}$ of the black matrix layer BM is larger than the light emitting region dimension $W_{EL}$ of the organic EL device. The difference value between the aperture dimension $W_{BM}$ of the black matrix layer BM and the light emitting region dimension $W_{EL}$ of the organic EL is desirably twice or more a margin in layering the opposed substrate 15 and the drive substrate 11.

$$W_{BM} - W_{EL} > 0 \qquad (11)$$

As illustrated in FIG. 1, if a display video in the organic EL display apparatus 1 is viewed in the air from the direction with an angle $\alpha$ (view angle $\alpha$) to the opposed substrate 15, a length $L_s$ of a shadow region formed on the light emitting sections 16R, 16G, and 16B caused by light shielding by the black matrix layer BM is expressed by the following Formula (12) based on Snell's law. Further, a dimension $L_B$ of a region actually light-shielded by the shadow region is expressed by the following Formula (13).

$$L_S = D * \tan\alpha \qquad (12)$$

$$L_B = L_S - (1/2) * (W_{BM} - W_{EL})$$
$$= D * \tan\alpha - 0.5 * (W_{BM} - W_{EL}) \qquad (13)$$

Thus, where the following Formula (14) is satisfied, the region actually light-shielded caused by light shielding by the black matrix layer BM does not exist. Therefore, in the view angle range from 0 deg to $\alpha$ both inclusive, vignetting of the display light L from the organic EL device caused by light shielding by the black matrix layer BM is never generated. Further, when Formula (14) is modified, it results in Formula (15). One of the conditions satisfying Formulas (14) and (15) is a case that the black matrix layer BM is formed directly above the light emitting sections 16R, 16G, and 16B.

$$L_B=D*\tan\alpha-0.5*(W_{BM}-W_{EL})\leq0 \quad (14)$$

$$\alpha\leq\tan^{-1}((W_{BM}-W_{EL})/(2*D)) \quad (15)$$

Further, in a general display apparatus, even if vignetting is generated at the view angle $\alpha$ equal to or more than 60 deg, it possibly leads to no large practical problem. The reason why $\alpha$=60 deg is adopted is as follows. For example, in the case where the optimal audio view distance is twice the width of a display apparatus and a viewer is located in a direction at 45 deg from the front face of the display screen, the viewer views an angle range of (45 deg $\pm$ 15 deg) as a field angle at once. It is regarded that 60 deg as the maximum angle in this case is not only a mathematical agreement but also is the angle as one index for a person skilled in the art. Thus, where $\alpha$=60 deg is assigned to Formulas (14) and (15), the following Formula (16) is established.

$$2\sqrt{3}\leq(W_{BM}-W_{EL})/D \quad (16)$$

In the case where the aperture ratio is small (in the case where value of $(W_{BM}-W_{EL})$ is large), it means that the film thickness of the protective layer 13 and the film thickness of the sealing layer 14 are significantly small. Thus, considering life lowering due to increase of the current density, heat resistance in the process and the like, the aperture ratio is desirably as large as possible (value of $(W_{BM}-W_{EL})$ is desirably as small as possible).

In the organic EL display apparatus 1 configured as above, by a drive signal supplied from the not-illustrated pixel drive circuit, a drive current is flown between the first electrode 161 and the second electrode 166 in the organic EL device in the respective light emitting sections 16R, 16G, and 16B. Thereby, electron hole recombination is generated, and light emission is initiated in the light emitting layer 164. Light from the light emitting layer 164 is transmitted through the second electrode 166, the protective layer 13, the sealing layer 14, the color filter layers 17R, 17G, and 17B, and the opposed substrate 15. After that, the light is extracted outside of the display apparatus. Thereby, video display based on the drive signal is made.

In this case, in the case where the foregoing Formula (11) and Formula (16) are satisfied, in the view angle $\alpha$ range from 0 to 60 deg both inclusive, vignetting of the display light L from the light emitting sections 16R, 16G, and 16B (organic EL device) caused by light shielding by the black matrix layer BM is never generated.

(Case with vignetting on some level)

Next, studies will be made on a case where the region actually light-shielded caused by light shielding by the black matrix layer BM exists in the angle range equal to or less than the view angle $\alpha$ (case where vignetting of the display light L from the light emitting sections 16R, 16G, and 16B (organic EL device) caused by light shielding by the black matrix layer BM is generated). Many actual display apparatuses are under such a condition, and thus the studies may provide a solution more corresponding to reality. In this case, considering the foregoing Formula (14) and Formula (15), the following Formula (17) and Formula (18) are established. Further, where $\alpha$=60 deg is assigned to Formulas (17) and (18) in the same manner as that of the foregoing case, the following Formula (19) is established.

$$L_B=D*\tan\alpha-0.5*(W_{BM}-W_{EL})>0 \quad (17)$$

$$\alpha>\tan^{-1}((W_{BM}-W_{EL})/(2*D)) \quad (18)$$

$$2\sqrt{3}>(W_{BM}-W_{EL})/D \quad (19)$$

Here, the ratio of vignetting of the display light L caused by light shielding by the black matrix layer BM (light shielding ratio of the display light L) is proportional to the ratio between the dimension $L_B$ of the region actually light-shielded by the portion of the shadow region and the light emitting region dimension $W_{EL}$ of the organic EL device. Thus, the vignetting ratio of the display light L is expressed by the following Formula (20). Therefore, to set the vignetting ratio of the display light L to a value equal to or less than 50%, it is enough that the following Formula (21) is satisfied. Where the following Formula (21) is modified by using Formula (17), the following Formula (22) is established.

$$(\text{vignetting ratio of display light L})=(L_B-W_{EL}) \qquad (20)$$

$$0.5{\geq}(L_B-W_{EL}){\geq}0 \quad (21)$$

$$0.5*W_{BM}{\geq}D*\tan\alpha{\geq}0.5*(W_{BM}-W_{EL}) \qquad (22)$$

In this case, studies are hereinafter made on an application range of the view angle $\alpha$ in the case where the vignetting of the display light L is generated as described above. In a mobile usage such as a cellular phone, the view angle $\alpha$ may be small to some degree. Meanwhile, in a usage such as a TV, the view angle $\alpha$ should be large to some degree. Considering this point, the application range of the view angle $\alpha$ is appropriately a numeral value range from 30 deg to 60 deg both inclusive. In the case where such a numeral value range is applied to Formula (22), the following formula (23) is established.

$$(\sqrt{3}/2)*W_{BM}{\geq}D{\geq}(1/2\sqrt{3})*(W_{BM}-W_{EL}) \qquad (23)$$

In the organic EL display apparatus 1 configured as above, when the foregoing Formula (11), Formula (19), and Formula (23) are satisfied, in the case where the aperture dimension $W_{BM}$ of the black matrix layer BM is larger than the light emitting region dimension $W_{EL}$ of the light emitting sections 16R, 16G, and 16B (organic EL device), even if vignetting of the display light L from the organic EL device caused by light shielding by the black matrix layer BM is generated in the view angle $\alpha$ range from 0 to 60 deg both inclusive, the vignetting ratio of the display light L is suppressed to a value equal to or less than 50%.

FIG. 3 illustrates an example of a relation between the view angle $\alpha$ and a relative luminance (relative luminance in the case where luminance is 100% where the view angle $\alpha$ is 0 deg) where the pixel pitch of the respective pixels 10R, 10G, and 10B is 100 $\mu$m; the aperture dimension $W_{BM}$ of the black matrix layer BM is 70 $\mu$m; the light emitting region dimension $W_{EL}$ of the light emitting sections 16R, 16G, and 16B (organic EL device) is 60 $\mu$m; and the air length D (=$\Sigma$di/ni) between the light emitting sections 16R, 16G, and 16B (organic EL device) and the black matrix layer BM is 30 $\mu$m. Where an average refractive index n between the light emitting sections 16R, 16G, and 16B (organic EL device) and the black matrix layer BM is 1.6, the view angle $\alpha$ at which vignetting of the display light L from the organic EL device caused by light shielding by the black matrix layer BM starts to be generated becomes 11.31 deg based on the foregoing Formula (17). Thus, it is found that light shielding (vignetting of the display light L) starts to be generated from a considerably low angle region, and the relative luminance is lowered down to a value equal to or less than 77.1% where $\alpha$ is 45 deg.

As described above, according to the display apparatus of this embodiment, in the case where the organic EL device (light emitting sections 16R, 16G, and 16B) as a self-luminous type light emitting device and the black matrix layer BM are provided, and the foregoing Formula (11) and Formula (16) are satisfied, in the view angle $\alpha$ range from 0 to 60 deg both inclusive, vignetting of the display light L from the light emitting sections 16R, 16G, and 16B (organic EL device) caused by light shielding by the black matrix layer BM is never generated. Thus, in the display apparatus including the self-luminous type light emitting device, view angle characteristics of luminance can be improved.

Further, in the case where the organic EL device (light emitting sections 16R, 16G, and 16B) as a self-luminous type light emitting device and the black matrix layer BM are provided, and the foregoing Formula (11), Formula (19), and Formula (23) are satisfied, when the aperture dimension $W_{BM}$ of the black matrix layer BM is larger than the light emitting region dimension $W_{EL}$ of the light emitting sections 16R, 16G, and 16B (organic EL device), even if vignetting of the display light L from the organic EL device caused by light shielding by the black matrix layer BM is generated in the view angle $\alpha$ range from 0 to 60 deg both inclusive, the vignetting ratio of the display light L is suppressed to a value equal to or less than 50%. Thus, in the display apparatus including the self-luminous type light emitting device, view angle characteristics of luminance can be improved.

[Second embodiment]

Next, a description will be given of a second embodiment of the present invention. For the same elements as the elements in the first embodiment, the same referential symbols will be affixed therewith, and descriptions thereof will be omitted as appropriate.

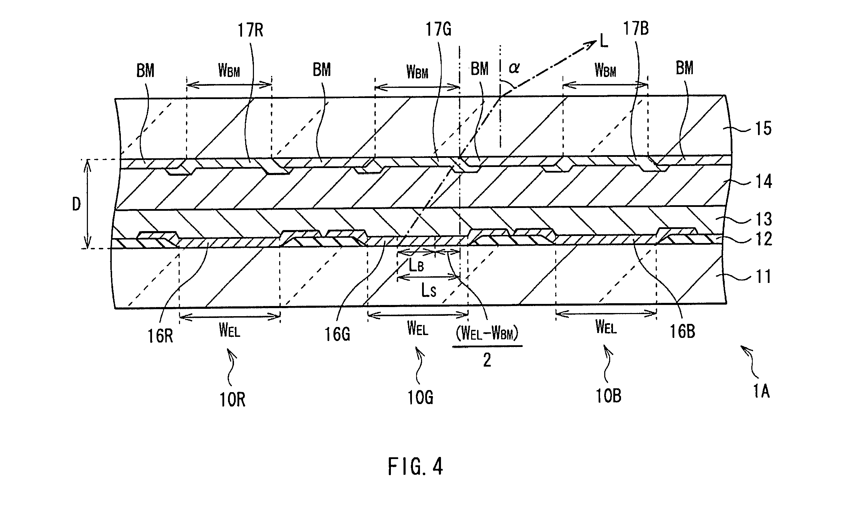

FIG. 4 illustrates a cross sectional configuration of a display apparatus (organic EL display apparatus 1A) according to this embodiment. In the organic EL display apparatus 1A, the aperture dimension $W_{BM}$ of the black matrix layer BM is formed with a size equal to or less than the light emitting region dimension $W_{EL}$ of the light emitting sections 16R, 16G, and 16B (organic EL device) (corresponding to a specific example of the light emitting region dimension $W_{LD}$) in the organic EL display apparatus 1 described in the first embodiment. In addition, the organic EL display apparatus 1A corresponds to an embodiment in a case that problems in the life, the power consumption and the like of the organic EL device are not much generated. That is, in the organic EL display apparatus 1A of this embodiment, first, the following Formula (24) is satisfied.

$$W_{BM}-W_{EL}\leq 0 \qquad (24)$$

An overlap amount as the difference value between the light emitting region dimension $W_{EL}$ of the organic EL device and the aperture dimension $W_{BM}$ of the black matrix layer BM ($W_{EL}-W_{BM}$) is desirably twice or more a margin in layering the opposed substrate 15 and the drive substrate 11. Further, in this embodiment, though light shielding on the front side is generated in the position at the view angle $\alpha$ of 0 degrees as well, the section that has been hidden becomes viewable. Thus, as long as a portion of shadow region by the black matrix layer BM is overlapped with the overlap region of the organic EL device and the black matrix layer BM, actual luminance lowering is not generated.

(Case with no vignetting)

Thus, in the organic EL display apparatus 1A of this embodiment, when the portion of shadow region by the black matrix layer BM is overlapped with the overlap region of the organic EL device and the black matrix layer BM described above, vignetting of the display light L can be perfectly prevented. That is, considering Formula (14) and Formula (15) in the first embodiment, if the following Formula (25) is established, vignetting of the display light L from the organic EL device caused by light shielding by the black matrix layer BM is never generated in the view angle range from 0 deg to $\alpha$ both inclusive.

$$\alpha\leq\tan^{-1}((W_{EL}-W_{BM})/(2*D)) \qquad (25)$$

Further, as described in the first embodiment, in a general display apparatus, even if vignetting is generated at the view angle $\alpha$ equal to or more than 60 deg, it possibly leads to no large practical problem. Further, as described in the first embodiment, the reason why $\alpha$=60 deg is adopted is as follows. That is, it is regarded that 60 deg is not only a mathematical agreement but also is the angle as one index for a person skilled in the art. Thus, where $\alpha$=60 deg is assigned to Formula (25), the following Formula (26) is established. However, in this case, as in the first embodiment, in the case where the aperture ratio is small (in the case where the value of ($W_{EL}-W_{BM}$) is large), it means that the film thickness of the protective layer 13 and the film thickness of the sealing layer 14 are significantly small. Thus, considering life lowering due to increase of the current density, heat resistance in the process and the like, the aperture ratio is desirably as large as possible (the value of ($W_{EL}-W_{BM}$) is desirably as small as possible).

$$2\sqrt{3}\leq(W_{EL}-W_{BM})/D \qquad (26)$$

In the organic EL display apparatus 1A configured as above, in the case where the foregoing Formula (24) and Formula (26) are satisfied, as in the first embodiment, in the view angle $\alpha$ range from 0 to 60 deg both inclusive, vignetting of the display light L from the light emitting sections 16R, 16G, and 16B (organic EL device) caused by light shielding by the black matrix layer BM is never generated.

(Case with vignetting on some level)

Next, as in the first embodiment, studies will be made on a case where the region actually light-shielded caused by light shielding by the black matrix layer BM exists in the angle range equal to or less than the view angle $\alpha$ (case that vignetting of the display light L from the light emitting sections 16R, 16G, and 16B (organic EL device) caused by light shielding by the black matrix layer BM is generated). In this case, considering the foregoing Formula (26), the following Formula (27) is established. Further, where $\alpha=60$ deg is assigned to Formula (27) in the same manner as that of the foregoing case, the following Formula (28) is established.

$$\alpha > \tan^{-1}((W_{EL}-W_{BM})/(2*D)) \qquad (27)$$

$$2\sqrt{3} > (W_{EL}-W_{BM})/D \qquad (28)$$

The ratio of vignetting of the display light L caused by light shielding by the black matrix layer BM (light shielding ratio of the display light L) is proportional to the ratio between the dimension $L_B$ of the region actually light-shielded by the portion of shadow region and the aperture dimension $W_{BM}$ of the black matrix layer BM. Thus, the vignetting ratio of the display light L is expressed by the following Formula (29). Therefore, to set the vignetting ratio of the display light L to a value equal to or less than 50%, it is enough that the following Formula (30) is satisfied. Where the following Formula (30) is modified, the following Formula (31) is established.

$$(\text{vignetting ratio of display light L})=(L_B/W_{BM}) \qquad (29)$$

$$0.5 \geq (L_B/W_{BM}) \geq 0 \qquad (30)$$

$$0.5*W_{EL} \geq D*\tan\alpha \geq 0.5*(W_{EL}-W_{BM}) \qquad (31)$$

Further, in the Formula (31), where the appropriate numeral value range from 30 deg to 60 deg both inclusive as an application range of the view angle $\alpha$ is applied as in the first embodiment, the following formula (32) is established.

$$(\sqrt{3}/2)*W_{EL} \geq D \geq (1/2\sqrt{3})*(W_{EL}-W_{BM}) \qquad (32)$$

In the organic EL display apparatus 1A configured as above, in the case where the foregoing Formula (24), Formula (28), and Formula (32) are satisfied, when the aperture dimension $W_{BM}$ of the black matrix layer BM is equal to or less than the light emitting region dimension $W_{EL}$ of the light emitting sections 16R, 16G, and 16B (organic EL device), even if vignetting of the display light L from the organic EL device caused by light shielding by the black matrix layer BM is generated in the view angle $\alpha$ range from 0 to 60 deg both inclusive, the vignetting ratio of the display light L is suppressed to a value equal to or less than 50%.

As described above, according to the display apparatus of this embodiment, in the case where the organic EL device (light emitting sections 16R, 16G, and 16B) as a self-luminous type light emitting device and the black matrix layer BM are provided, and the foregoing Formula (24) and Formula (26) are satisfied, in the view angle $\alpha$ range from 0 to 60 deg both inclusive, vignetting of the display light L from the light emitting sections 16R, 16G, and 16B (organic EL device) caused by light shielding by the black matrix layer BM is never generated. Thus, in the display apparatus including the self-luminous type light emitting device, view angle characteristics of luminance can be improved.

Further, in the case where the organic EL device (light emitting sections 16R, 16G, and 16B) as a self-luminous type light emitting device and the black matrix layer BM are provided, and the foregoing Formula (24), Formula (28), and Formula (32) are satisfied, when the aperture dimension $W_{BM}$ of the black matrix layer BM is equal to or less than the light emitting region dimension $W_{EL}$ of the light emitting sections 16R, 16G, and 16B (organic EL device), even if vignetting of the display light L from the organic EL device caused by light shielding by the black matrix layer BM is generated in the view angle $\alpha$ range from 0 to 60 deg both inclusive, the vignetting ratio of the display light L is suppressed to a value equal to or less than 50%. Thus, in the display apparatus including the self-luminous type light emitting device, view angle characteristics of luminance can be improved.

While the invention has been described with reference to the first and the second embodiments, the invention is not limited to these embodiments, and various modifications are able to be made.

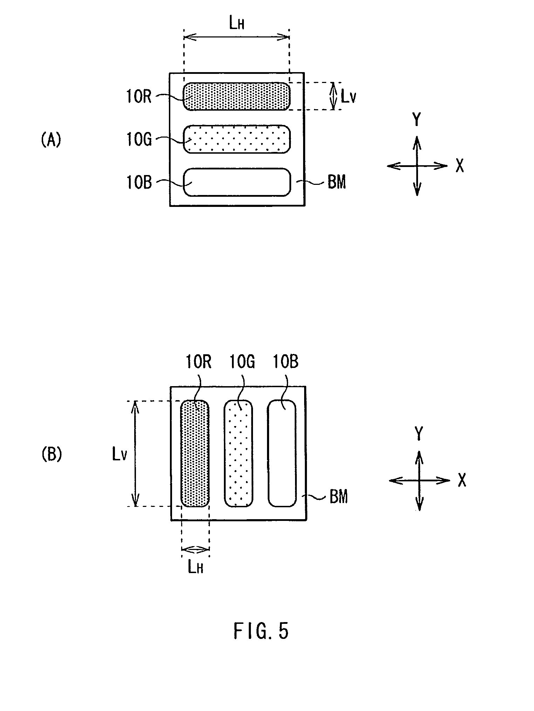

For example, in the display apparatus of the present invention, for example, as illustrated in FIG. 5(A), in the respective pixels 10R, 10G, and 10B, the aperture dimension $W_{BM}$ of the black matrix layer and the light emitting region dimension $W_{EL}$ of the light emitting device (light emitting sections 16R, 16G, and 16B) in the horizontal direction (X direction in the figure) are preferably longer than those in the vertical direction (Y direction in the figure) (a dimension $L_H$ in the horizontal direction of the pixel is preferably longer than a dimension $L_v$ in the vertical direction of the pixel), respectively. That is, the configuration illustrated in FIG. 5(A) is more preferable than a configuration in which in the respective pixels 10R, 10G, and 10B, the aperture dimension $W_{BM}$ of the black matrix layer and the light emitting region dimension $W_{EL}$ of the light emitting device (light emitting sections 16R, 16G, and 16B) in the vertical direction are longer than those in the horizontal direction (the dimension $L_v$ in the vertical direction of the pixel is longer than the dimension $L_H$ in the horizontal direction of the pixel) as illustrated in FIG. 5(B), for example. The reason thereof is as follows. In general, regarding audio visual direction, visibility in the horizontal direction is high. Considering such a fact, when a pixel shape is made so that the pixel pitch is increased in the horizontal direction necessitating a large view angle in actual usage, and the pixel pitch is decreased in the vertical direction not necessitating a large view angle in actual usage, it is possible to further improve the view angle characteristics of luminance in the horizontal direction in addition to the effects in the foregoing embodiments.

Further, in the foregoing embodiments, the description has been given of the organic EL display apparatuses 1 and 1 A including the organic EL device in the light emitting sections 16R, 16G, and 16B as an example of a self-luminous type display apparatus including a self-luminous type light emitting device. However, the present invention is applicable to an inorganic EL display apparatus including an inorganic EL device as a self-luminous type light emitting device and other self-luminous type display apparatus such as an FED (Field Emission Display).

## Claims

1. A display apparatus in which a plurality of pixels are arranged in a state of matrix as a whole, comprising:

   a pair of substrates;
   a self-luminous type light emitting device formed in a region corresponding to each pixel on one substrate of the pair of substrates; and
   a black matrix layer formed in a region corresponding to a portion between each pixel on the other substrate of the pair of substrates, and
   satisfying the following Formula (41) :

$$2\sqrt{3} \leq (\left| W_{BM} - W_{LD} \right| / D) \quad (41)$$

   where $W_{BM}$ represents an aperture dimension of the black matrix layer; $W_{LD}$ represents a light emitting region dimension of the light emitting device; and D represents an air length between the light emitting device and the black matrix layer.

2. The display apparatus according to claim 1, wherein in each pixel, the aperture dimension $W_{BM}$ of the black matrix layer and the light emitting region dimension $W_{LD}$ of the light emitting device in the horizontal direction are respectively longer than the aperture dimension $W_{BM}$ of the black matrix layer and the light emitting region dimension $W_{LD}$ of the light emitting device in the vertical direction.

3. The display apparatus according to claim 1, wherein the light emitting device is an organic EL device, and the display apparatus is configured as an organic EL display apparatus.

4. A display apparatus in which a plurality of pixels are arranged in a state of matrix as a whole, comprising:

   a pair of substrates;
   a self-luminous type light emitting device formed in a region corresponding to each pixel on one substrate of the pair of substrates; and
   a black matrix layer formed in a region corresponding to a portion between each pixel on the other substrate of the pair of substrates, and
satisfying the following Formula (42) to Formula (44):

$$2\sqrt{3} > (|W_{BM} - W_{LD}|/D) \quad (42)$$

$$W_{LD} < W_{BM} \quad (43)$$

$$(\sqrt{3}/2)*W_{BM} \geq D \geq (1/2\sqrt{3})*(W_{BM} - W_{LD}) \quad (44)$$

where $W_{BM}$ represents an aperture dimension of the black matrix layer; $W_{LD}$ represents a light emitting region dimension of the light emitting device; and D represents an air length between the light emitting device and the black matrix layer.

5. The display apparatus according to claim 4, wherein in each pixel, the aperture dimension $W_{BM}$ of the black matrix layer and the light emitting region dimension $W_{LD}$ of the light emitting device in the horizontal direction are respectively longer than the aperture dimension $W_{BM}$ of the black matrix layer and the light emitting region dimension $W_{LD}$ of the light emitting device in the vertical direction.

6. The display apparatus according to claim 4, wherein the light emitting device is an organic EL device, and the display apparatus is configured as an organic EL display apparatus.

7. A display apparatus in which a plurality of pixels are arranged in a state of matrix as a whole, comprising
a pair of substrates;
a self-luminous type light emitting device formed in a region corresponding to each pixel on one substrate of the pair of substrates; and
a black matrix layer formed in a region corresponding to a portion between each pixel on the other substrate of the pair of substrates, and
satisfying the following Formula (45) to Formula (47):

$$2\sqrt{3} > (|W_{BM} - W_{LD}|/D) \quad (45)$$

$$W_{LD} \geq W_{BM} \quad (46)$$

$$(\sqrt{3}/2)*W_{LD} \geq D \geq (1/2\sqrt{3})*(W_{LD} - W_{BM}) \quad (47)$$

where $W_{BM}$ represents an aperture dimension of the black matrix layer; $W_{LD}$ represents a light emitting region dimension of the light emitting device; and D represents an air length between the light emitting device and the black matrix layer.

8. The display apparatus according to claim 7, wherein in each pixel, the aperture dimension $W_{BM}$ of the black matrix layer and the light emitting region dimension $W_{LD}$ of the light emitting device in the horizontal direction are respectively longer than the aperture dimension $W_{BM}$ of the black matrix layer and the light emitting region dimension $W_{LD}$ of the light emitting device in the vertical direction.

9. The display apparatus according to claim 7, wherein the light emitting device is an organic EL device, and the display apparatus is configured as an organic EL display apparatus.

F I G. 1

EP 2 187 463 A1

166
165
164
163
162

12
161

11

W_EL

12-1

FIG. 2

110
100
90
80
70
60
50
40
30
20
10
0

RELATIVE LUMINANCE (%)

11.31°

77.1°

LIGHT
SHIELDING
REGION

0    10    20    30    40    50    60    70

VIEW ANGLE (°)

FIG. 3

FIG. 4

EP 2 187 463 A1

FIG. 5

## INTERNATIONAL SEARCH REPORT

| | International application No. |
|---|---|
| | PCT/JP2008/065293 |

**A. CLASSIFICATION OF SUBJECT MATTER**
*H01L51/50*(2006.01)i, *G09F9/30*(2006.01)i, *H01L27/32*(2006.01)i, *H05B33/02* (2006.01)i, *H05B33/12*(2006.01)i

According to International Patent Classification (IPC) or to both national classification and IPC

**B. FIELDS SEARCHED**

Minimum documentation searched (classification system followed by classification symbols)
H01L51/50, G09F9/30, H01L27/32, H05B33/02, H05B33/12

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | WO 98/34437 A1  (Idemitsu Kosan Co., Ltd.),<br>06 August, 1998 (06.08.98),<br>Description, page 8, lines 11 to 14; page 57,<br>line 27 to page 58, line 15; page 66, lines 10<br>to 14; table 5; Fig. 2(c)<br>& JP 3224237 B          & US 5869929 A<br>& US 6344712 B1         & US 2002/0021087 A1<br>& EP 892589 A1          & WO 1998/034437 A1<br>& DE 69823276 T         & DE 69823276 D<br>& TW 441220 B           & CN 1216209 A | 1,3,4,6,7,9<br>2,5,8 |
| X<br>Y | JP 2006-73219 A  (Sony Corp.),<br>16 March, 2006 (16.03.06),<br>Par. Nos. [0015] to [0048], [0058] to [0062];<br>Figs. 1, 2<br>& US 2006/0043888 A1    & KR 10-2006-0050803 A<br>& CN 1744784 A | 4,6<br>5 |

☒ Further documents are listed in the continuation of Box C.          ☐ See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>27 November, 2008 (27.11.08) | Date of mailing of the international search report<br>09 December, 2008 (09.12.08) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/065293

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2006-338012 A  (L.G. Philips LCD Co., Ltd.), 14 December, 2006 (14.12.06), Par. Nos. [0021], [0030], [0045] & US 2006/0267490 A1     & GB 2426864 A & GB 610763 D0          & DE 102006024448 A & KR 10-2006-0124145 A  & CN 1917228 A | 2,5,8 |
| Y | JP 2007-12611 A  (Samsung Electronics Co., Ltd.), 18 January, 2007 (18.01.07), Par. No. [0037]; Fig. 6 & US 2007/0035242 A1     & KR 10-2007-0001303 A & CN 1893106 A | 2,5,8 |
| A | JP 63-148597 A  (Hitachi, Ltd.), 21 June, 1988 (21.06.88), Full text; all drawings (Family: none) | 1-9 |

Form PCT/ISA/210 (continuation of second sheet) (April 2007)

# EP 2 187 463 A1

## INTERNATIONAL SEARCH REPORT

International application No.

PCT/JP2008/065293

| Box No. II | Observations where certain claims were found unsearchable (Continuation of item 2 of first sheet) |

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| Box No. III | Observations where unity of invention is lacking (Continuation of item 3 of first sheet) |

This International Searching Authority found multiple inventions in this international application, as follows:

A feature common to the inventions in claims 1-3 and the inventions in claims 4-6 is a structure having a plurality of pixels arranged in a matrix as a whole, and provided with a pair of substrates, a self-light-emission type light emitting device formed on one of the pair of substrates in an area corresponding to each pixel, and a black matrix layer on the other of the pair of substrates in an area corresponding to each pixel. Since the common feature is disclosed in the document: WO 98/34437 A1 (Idemitsu Kosan Co., Ltd.), 6 August, 1998 (06.08.98), page 8, lines 11-14, Fig. 2(c), it cannot be deemed to be a technical feature that makes a contribution over the prior art. (continued to extra sheet)

1. ☒ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

19

**INTERNATIONAL SEARCH REPORT**

International application No.

PCT/JP2008/065293

Continuation of Box No.III of continuation of first sheet(2)

Therefore, since the inventions are not technically related to involve one or more of the same or corresponding special technical features, they cannot be deemed to be linked to form a single general inventive concept.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006073219 A